(19) Europäisches Patentamt
European Patent Office
Office européen des brevets

(11) **EP 3 651 369 B1**

(12) **FASCICULE DE BREVET EUROPEEN**

(45) Date de publication et mention de la délivrance du brevet:
**16.08.2023 Bulletin 2023/33**

(21) Numéro de dépôt: **19207043.1**

(22) Date de dépôt: **05.11.2019**

(51) Classification Internationale des Brevets (IPC):
*H04B 1/06* *(2006.01)*       *H04B 17/00* *(2015.01)*
*H04B 7/00* *(2006.01)*

(52) Classification Coopérative des Brevets (CPC):
**H04B 1/06; H03F 1/32; H03F 3/19; H03G 3/3052;**
H03F 2200/451

(54) **DISPOSITIF ÉLECTRONIQUE ET PROCÉDÉ DE RÉCEPTION D'UN SIGNAL RADIOÉLECTRIQUE, CIRCUIT INTÉGRÉ IMPLÉMENTANT UN TEL DISPOSITIF**

ELEKTRONISCHE VORRICHTUNG UND VERFAHREN ZUM EMPFANG EINES RADIOSIGNALS, INTEGRIERTE SCHALTUNG, DIE EINE SOLCHE VORRICHTUNG AUSFÜHRT

ELECTRONIC DEVICE AND METHOD FOR RECEIVING A RADIO SIGNAL, INTEGRATED CIRCUIT IMPLEMENTING SUCH A DEVICE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **06.11.2018 FR 1860197**

(43) Date de publication de la demande:
**13.05.2020 Bulletin 2020/20**

(73) Titulaire: **Parrot Faurecia Automotive SAS 75010 Paris (FR)**

(72) Inventeur: **LAURY, Cyril 92160 ANTONY (FR)**

(74) Mandataire: **Lavoix 2, place d'Estienne d'Orves 75441 Paris Cedex 09 (FR)**

(56) Documents cités:
**US-A- 6 134 430          US-A1- 2003 181 180
US-A1- 2005 277 395      US-A1- 2008 102 773
US-B1- 6 208 849**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**Description**

La présente invention concerne un dispositif électronique de réception d'un signal radioélectrique, le dispositif comprenant un amplificateur amont configuré pour amplifier un signal radioélectrique reçu, un module de pilotage configuré pour piloter un gain de l'amplificateur amont et un mélangeur, connecté en sortie de l'amplificateur amont, le mélangeur étant configuré pour mélanger le signal issu de l'amplificateur amont avec un signal de référence.

L'invention concerne également un circuit intégré implémentant un tel dispositif électronique de réception d'un signal radioélectrique.

L'invention concerne aussi un procédé de réception d'un signal radioélectrique, le procédé étant mis en oeuvre par un tel dispositif électronique de réception.

L'invention concerne le domaine des syntoniseurs (de l'anglais *tuner*), c'est-à-dire des appareils électroniques permettant de recevoir un signal électromagnétique émis sur une bande de fréquences, de conserver la partie du signal émise sur une fréquence particulière, également appelée fréquence utile, et de rejeter les parties du signal émises sur les autres fréquences. L'invention concerne plus particulièrement les syntoniseurs analogiques, quelle que soit la gamme d'ondes radioélectriques concernée. L'invention concerne par exemple les syntoniseurs radio, tel que les syntoniseurs FM (de l'anglais *Frequency Modulation*), AM (de l'anglais *Amplitude Modulation*), DAB (de l'anglais *Digital Audio Broadcasting*)*,* ou encore HD Radio. L'invention concerne aussi les syntoniseurs TV, tels que les syntoniseurs DVB-T (de l'anglais *Digital Video Broadcasting - Terrestrial*), DVB-T 2, ISDB-T/Tsb (de l'anglais *Integrated Services Digital Broadcasting - Terrestrial/ Terrestrial Sound Broadcast*) ou encore CTTB (de l'anglais *China Terrestrial Télévision Broadcasting*)*.*

On connaît du document US 2004/0043733 A1 un dispositif électronique de réception du type précité. Le dispositif de réception comprend un amplificateur amont amplifiant un signal radioélectrique reçu via une antenne, un module WBAGC (de l'anglais *Wide Band Automatic Gain Control*) de pilotage du gain de l'amplificateur amont, et un mélangeur connecté en sortie de l'amplificateur amont et mélangeant le signal issu de l'amplificateur amont avec un autre signal. Ce dispositif de réception comprend en outre un amplificateur aval connecté en sortie du mélangeur et un détecteur d'intermodulation apte à détecter une intermodulation à partir du signal délivré par l'amplificateur aval, et à générer, le cas échéant, un indicateur d'intermodulation, à destination du module de pilotage WBAGC, afin que ce dernier adapte ensuite le gain de l'amplificateur amont en fonction d'une éventuelle intermodulation détectée. Le dispositif de réception est un dispositif de réception de signaux radio FM, et le détecteur d'intermodulation détecte une intermodulation à partir de variations de fréquences importantes au-delà d'écarts FM standards et d'un bruit associé résultant de larges spectres de fréquences.

Le document US 2008/0102773 A1 concerne aussi un dispositif électronique de réception du type précité. Il comprend un amplificateur amont amplifiant un signal radioélectrique reçu d'une antenne, un contrôleur de gain pilotant le gain de l'amplificateur amont, un mélangeur connecté en sortie de l'amplificateur amont et mélangeant le signal issu de l'amplificateur amont avec un autre signal, un amplificateur aval connecté en sortie du mélangeur et un convertisseur analogique numérique connecté en sortie de l'amplificateur aval. Le dispositif de réception comprend en outre un détecteur de produits d'intermodulation à partir du signal issu du convertisseur analogique-numérique, le contrôleur de gain étant alors adapté pour modifier le gain de l'amplificateur amont en fonction de la détection ou non de tels produits d'intermodulation. Les produits d'intermodulation sont par exemple détectés via un taux de variation de l'augmentation du bruit dans un ou plusieurs canaux adjacents au canal acheminant le signal radioélectrique, ou encore en détectant directement ces produits d'intermodulation sur une bande de garde comprenant une partie du canal transportant le signal radioélectrique.

Le document US 2008/0153447 A1 décrit également un dispositif électronique de réception du type précité. Ce dispositif de réception comprend un amplificateur de gain variable amplifiant un signal radioélectrique reçu, un contrôleur du gain de l'amplificateur et un mélangeur connecté en sortie de l'amplificateur et mélangeant le signal issu de l'amplificateur avec un autre signal. Le dispositif de réception comprend en outre un détecteur aval connecté en sortie du mélangeur et un détecteur amont connecté en entrée du mélangeur, les détecteurs amont et aval étant aptes à détecter des interférences, et notamment un phénomène d'intermodulation, le détecteur aval connecté détectant si un signal interférant est présent sur une fréquence adjacente à 6 MHz de la fréquence utile, correspondant à un décalage N+1, et le détecteur amont détectant si un signal interférant est présent sur une fréquence adjacente au-delà de 6 MHz de la fréquence utile, typiquement à 18 MHz de la fréquence du signal utile correspondant à un décalage N+3. Le contrôleur adapte alors le gain de l'amplificateur en fonction de la détection ou non d'une intermodulation.

Les documents US 6,134,430 A et US 2003/181180 A1 décrivent aussi un dispositif électronique de réception du type précité.

Toutefois, avec de tels dispositifs de réception, la détection d'une intermodulation est relativement complexe, et nécessite dans certains cas plusieurs détecteurs.

Le document US 7,379,725 décrit également un dispositif électronique de réception.

Le but de l'invention est alors de proposer un dispositif électronique de réception d'un signal radioélectrique permettant de détecter plus facilement une intermodulation.

A cet effet, l'invention a pour objet un dispositif électronique de réception d'un signal radioélectrique, selon la revendication 1.

Avec le dispositif électronique de réception selon l'invention, le module de pilotage permet alors d'effectuer simplement une détection d'intermodulation, en commandant la génération d'une majoration de gain au niveau de l'amplificateur amont et en comparant la première puissance mesurée en l'absence de majoration de gain avec la deuxième puissance mesurée en présence de la majoration de gain, les première et deuxième puissances étant des puissances du signal issu du mélangeur.

Autrement dit, avec le dispositif de réception selon l'invention, une intermodulation est détectée lorsqu'une majoration de puissance, commandée par le module de pilotage et générée dans le but d'effectuer cette détection d'intermodulation, engendre une variation anormale de la puissance du signal en sortie du mélangeur, notamment une variation non-linéaire de cette puissance.

Suivant d'autres aspects avantageux de l'invention, le dispositif électronique de réception est selon l'une quelconque des revendications 2 à 9.

L'invention a également pour objet un circuit intégré selon la revendication 10.

L'invention a également pour objet un procédé de réception d'un signal radioélectrique, selon la revendication 11.

Ces caractéristiques et avantages de l'invention apparaîtront plus clairement à la lecture de la description qui va suivre, donnée uniquement à titre d'exemple non limitatif, et faite en référence aux dessins annexés, sur lesquels :

- la figure 1 est une représentation schématique d'un dispositif électronique de réception selon l'invention ; et
- la figure 2 est un organigramme d'un procédé de réception d'un signal radioélectrique selon l'invention, le procédé étant mis en oeuvre par le dispositif de réception de la figure 1.

Dans la suite de la description, l'expression « sensiblement égal à » s'entend comme une relation d'égalité à plus ou moins 10%, c'est-à-dire avec une variation d'au plus 10% ; de préférence encore comme une relation d'égalité à plus ou moins 5%, c'est-à-dire avec une variation d'au plus 5%.

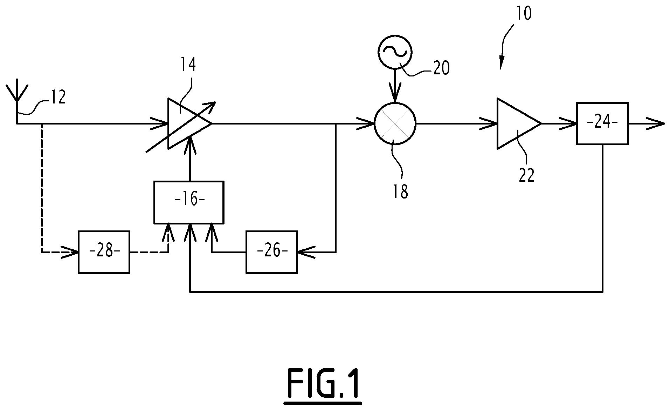

Sur la figure 1, un dispositif électronique de réception 10 est configuré pour recevoir un signal radioélectrique. Le dispositif électronique de réception 10 est typiquement un syntoniseur (de l'anglais *tuner*), c'est-à-dire un appareil permettant de recevoir un signal électromagnétique émis sur une bande de fréquences, de conserver la partie du signal émise sur une fréquence particulière, dite fréquence utile, et de rejeter les parties du signal émises sur les fréquences autres que la fréquence utile.

Le dispositif électronique de réception 10 est par exemple un syntoniseur analogique configuré pour syntoniser des signaux émis de façon analogique, quelle que soit la gamme d'ondes radioélectriques associée. Le syntoniseur est par exemple un syntoniseur radio, tel qu'un syntoniseur FM apte à recevoir un signal radioélectrique émis dans la gamme de fréquences comprise entre 87,5 MHz et 108 MHz ; ou un syntoniseur AM apte à recevoir un signal radioélectrique compris dans la gamme de fréquences comprise entre 148,5 kHz et 283,5 kHz et/ou entre 526,5 kHz et 1606,5 kHz ; ou un syntoniseur DAB ; ou encore un syntoniseur HD Radio. En variante, le syntoniseur est un syntoniseur TV, tel qu'un syntoniseur DVB-T ; ou un syntoniseur DVB-T 2 ; ou un syntoniseur ISDB-T ; ou encore un syntoniseur CTTB. Le syntoniseur TV est par exemple apte à recevoir un signal radioélectrique émis dans la gamme de fréquences comprise entre 40 MHz et 860 MHz.

Le dispositif électronique de réception 10 comprend une antenne radioélectrique 12 apte à recevoir un signal radioélectrique, un amplificateur amont 14 connecté à l'antenne radioélectrique 12 et configuré pour amplifier le signal radioélectrique reçu par l'antenne 12, l'amplificateur amont 14 étant de préférence un amplificateur à gain variable, également appelé VGA (de l'anglais *Variable Gain Amplifier*) *et* comme symbolisé par la flèche associée au symbole triangulaire d'amplification sur la figure 1.

Le dispositif électronique de réception 10 comprend un module de pilotage 16 configuré pour piloter un gain G de l'amplificateur amont 14 et un mélangeur 18 (de l'anglais *mixer)* connecté en sortie de l'amplificateur amont 14, le mélangeur 18 étant configuré pour mélanger le signal issu de l'amplificateur amont 14 avec un signal de référence, tel qu'un signal issu d'un oscillateur 20 auquel est alors connecté le mélangeur 18.

En complément, le dispositif électronique de réception 10 comprend un amplificateur aval 22 connecté en sortie du mélangeur 18 et un convertisseur analogique-numérique 24, également appelé ADC (de l'anglais *Analog to Digital Converter*), le convertisseur analogique-numérique 24 étant connecté en sortie de l'amplificateur aval 22.

En complément facultatif, le dispositif électronique de réception 10 comprend un premier détecteur à large bande 26, également appelé WBD (de l'anglais *Wide Band Détecter*), connecté entre la sortie de l'amplificateur amont 14 et le module de pilotage 16, le premier détecteur à large bande 26 étant apte à mesurer une puissance du signal radioélectrique entre l'amplificateur amont 14 et le mélangeur 18, également appelé signal utile.

En complément facultatif encore, le dispositif électronique de réception 10 comprend un deuxième détecteur à large bande 28 connecté entre l'antenne radioélectrique 12 et le module de pilotage 16, le deuxième détecteur à large bande 28 étant apte à mesurer la puissance du signal reçu par l'antenne 12.

Le dispositif électronique de réception 10 est par exemple réalisé sous forme d'un ou plusieurs circuits intégrés dédiés, tels qu'un ou plusieurs ASIC (de l'anglais *Application Spécifie Integrated Circuit*).

L'antenne radioélectrique 12 est connue en soi, et est de forme adaptée à la gamme d'ondes radioélectriques aptes à être reçues par le dispositif électronique de réception 10, qu'il s'agisse de la gamme radio (AM, FM, DAB, HD Radio, ISDB-Tsb) ou encore d'une gamme TV (DVB-T, DVB-T 2, ISDB-T, CTTB), décrites précédemment.

L'amplificateur amont 14 est également connu en soi, et présente un gain G dont la valeur est apte à être pilotée par le module de pilotage 16.

Selon l'invention, le module de pilotage 16 est configuré en outre pour effectuer une détection d'intermodulation, en commandant la génération par l'amplificateur amont 14 d'une majoration de gain ∆G et en comparant une première puissance P1 avec une deuxième puissance P2. Les première P1 et deuxième P2 puissances sont des puissances respectives du signal en sortie du mélangeur 18, c'est-à-dire du signal issu du mélangeur 18, la première puissance P1 étant mesurée en l'absence de majoration de gain de l'amplificateur amont 14, et la deuxième puissance P2 étant mesurée en présence de la majoration de gain ∆G.

Par première puissance P1 en l'absence de majoration de gain, on entend la puissance du signal issu du mélangeur 18, par exemple mesurée via le convertisseur analogique-numérique 24, correspondant au gain par défaut de l'amplificateur amont 14, sans la majoration de gain ∆G, par exemple à un gain nominal, noté $G_{nom}$. Selon ce dernier exemple, la première puissance P1 est alors également notée $P(G_{nom})$, ou encore $P_{ADC}(G_{nom})$ lorsqu'elle est mesurée via le convertisseur analogique-numérique 24, également appelé ADC.

Par deuxième puissance P2 en présence de la majoration de gain ∆G, on entend la puissance du signal issu du mélangeur 18, par exemple mesurée via le convertisseur analogique-numérique 24, correspondant au même gain par défaut de l'amplificateur amont 14 avec en outre la majoration de gain ∆G, c'est-à-dire correspond à la somme dudit gain par défaut et de la majoration de gain ∆G. Dans l'exemple où ledit gain par défaut est le gain nominal $G_{nom}$, la deuxième puissance P2 est alors également notée $P(G_{nom}+∆G)$, ou encore $P_{ADC}(G_{nom}+∆G)$ lorsqu'elle est mesurée via le convertisseur analogique-numérique 24, également appelé ADC.

Les première et deuxième puissances P1, P2 sont par exemple mesurées par le convertisseur analogique numérique 24, et le module de pilotage 16 est alors relié audit convertisseur analogique numérique 24.

Le module de pilotage 16 est par exemple configuré pour détecter une intermodulation, c'est-à-dire pour considérer qu'une intermodulation est présente, si une différence entre la deuxième puissance P2 et la première puissance P1 est supérieure à sensiblement 1,5 fois la majoration de gain ∆G. Autrement dit, dans cet exemple, lorsque les première P1 et deuxième P2 puissances, ainsi que la majoration de gain ∆G, sont exprimées en décibels, une intermodulation est détectée si la différence entre la deuxième puissance P2 et la première puissance P1 est sensiblement supérieure à ∆G+2dB.

Selon cet exemple, une intermodulation est alors détectée si l'inéquation suivante est vérifiée :

$$P2 - P1 > ∆G + 2dB \qquad (1)$$

avec P1 = $P(G_{nom})$, par exemple P1 = $P_{ADC}(G_{nom})$,
P2 = $P(G_{nom}+∆G)$, par exemple P2 = $P_{ADC}(G_{nom}+∆G)$,
P1 et P2 étant exprimées en dB.

De préférence, une intermodulation est détectée si l'inéquation suivante est vérifiée :

$$P2 - P1 > ∆G + 3dB \qquad (2)$$

avec P1 = $P(G_{nom})$, par exemple P1 = $P_{ADC}(G_{nom})$,
P2 = $P(G_{nom}+∆G)$, par exemple P2 = $P_{ADC}(G_{nom}+∆G)$,
P1 et P2 étant exprimées en dB.

La majoration de gain ∆G est de préférence de courte durée afin de perturber le moins possible le signal délivré en sortie du dispositif de réception 10. La majoration de gain ∆G est par exemple une impulsion de gain ayant une brève durée, telle qu'une durée inférieure à 100 µs, de préférence sensiblement égale à 50 µs.

La majoration de gain ∆G est de préférence supérieure à la valeur par défaut du gain G. La majoration de gain ∆G dépend d'une amplitude du signal radioélectrique reçu et d'une amplitude maximale du signal avant saturation du dispositif électronique de réception 10, en particulier avant saturation du convertisseur analogique-numérique 24. L'amplitude de la majoration de gain ΔG est par exemple égale à la différence entre ladite amplitude maximale avant saturation et l'amplitude du signal radioélectrique reçu.

Le module de pilotage 16 est configuré pour commander répétitivement la génération de la majoration de gain ΔG.

L'homme du métier comprendra que par répétitivement, on entend une réitération à intervalle temporel successif, la génération répétitive de la majoration de gain ΔG étant de préférence sensiblement périodique, avec par exemple une périodicité sensiblement égale à 1 ms, tant qu'aucune modulation n'a été détectée et tant que le gain de l'amplificateur amont 14 est inférieur au gain maximal amont prédéfini $G_{max}$.

En complément, le module de pilotage 16 est configuré pour augmenter l'écart temporel entre une nouvelle majoration de gain $\Delta G_{n+1}$ générée à un instant temporel $t_{n+1}$ et une dernière majoration de gain $\Delta G_n$ générée à un instant temporel $t_n$ en cas de détection d'une intermodulation suite à la dernière majoration de gain $\Delta G_n$. Autrement dit, en cas de détection d'une intermodulation, le module de pilotage 16 est alors configuré pour espacer temporellement la prochaine majoration de gain $\Delta G_{n+1}$ par rapport à la dernière majoration de gain $\Delta G_n$ ayant engendré la détection de cette intermodulation. Ceci permet de limiter d'éventuelles oscillations du signal utile, et d'éviter que la détection d'intermodulation n'engendre une perturbation du signal délivré en sortie du dispositif de réception 10.

L'écart temporel entre deux majorations successives de gain $\Delta G_n$, $\Delta G_{n+1}$, c'est-à-dire la différence temporelle entre les instants temporels $t_n$ et $t_{n+1}$, est par exemple sensiblement égale à 1 ms si aucune intermodulation n'a été détectée suite à la dernière majoration de gain $\Delta G_n$ et si le gain G de l'amplificateur amont 14 est inférieur à un gain maximal amont prédéfini $G_{max}$.

Si une intermodulation a été détectée suite à la dernière majoration de gain $\Delta G_n$, alors l'écart temporel entre l'instant temporel $t_n$ de génération de la dernière majoration de gain $\Delta G_n$ et l'instant temporel $t_{n+1}$ de génération de la prochaine majoration de gain $\Delta G_{n+1}$ est par exemple sensiblement égal à 20 ms.

Si le gain G de l'amplificateur amont 14 est sensiblement égal au gain maximal amont prédéfini $G_{max}$, alors l'écart temporel entre deux instants temporels successifs $t_n$, $t_{n+1}$ de majorations successives de gain $\Delta G_n$, $\Delta G_{n+1}$ est supérieur à celui faisant suite à une détection d'intermodulation, et est par exemple sensiblement égal à 50 ms.

Autrement dit, pour effectuer une détection d'intermodulation, le module de pilotage 16 est configuré pour augmenter sur une brève durée, et de préférence répétitivement, le gain de l'amplification amont et pour mesurer ensuite l'augmentation de puissance sur le signal issu du mélangeur 18. Si l'augmentation de puissance est du même ordre que la variation de l'amplification, c'est-à-dire si la variation de la puissance du signal issu du mélangeur en fonction de la variation du gain est sensiblement linéaire, alors le module de pilotage 16 considère que le dispositif de réception 10 n'est pas en situation d'intermodulation. Au contraire, si l'augmentation de puissance est très supérieure à la variation de gain de l'amplification amont, le module de pilotage 16 considère qu'une intermodulation est présente.

Le module de pilotage 16 est configuré en outre pour appliquer ou non des consignes issues du premier détecteur à large bande 26, et en complément facultatif du deuxième détecteur à large bande 28, en fonction de la détection ou non d'une intermodulation. Plus précisément, si le module de pilotage 16 considère qu'aucune intermodulation n'est présente, alors il est configuré pour ignorer les consignes issues du ou des détecteurs à large bande 26, 28. Sinon, si le module de pilotage 16 considère qu'une intermodulation est présente, il est alors configuré pour appliquer chaque consigne de modification de gain issue du ou des détecteurs à large bande 26, 28.

En complément facultatif, le module de pilotage 16 est en outre configuré pour, préalablement à la détection d'intermodulation, effectuer un test de présence d'au moins un signal adjacent parasite, par exemple d'au moins un signal adjacent fort. Le module de pilotage 16 est alors configuré pour effectuer la détection d'intermodulation seulement si le test de présence est positif, c'est-à-dire si au moins un signal adjacent parasite est considéré comme présent, ledit test de présence dépendant de la puissance du signal en sortie du mélangeur 18 et du gain G de l'amplificateur amont 14.

Le test de présence est par exemple positif si le gain G de l'amplificateur amont est inférieur au gain maximal amont prédéfini $G_{max}$, de préférence très inférieur audit gain maximal amont prédéfini $G_{max}$, et si la puissance du signal en sortie du mélangeur 18, par exemple mesurée par le convertisseur analogique-numérique 24, est strictement inférieure à une puissance cible prédéfinie $P_c$. Le test de présence est négatif si les conditions précitées ne sont pas remplies.

Par gain très inférieur audit gain maximal amont prédéfini $G_{max}$, on entend par exemple un gain inférieur d'au moins 2dB par rapport audit gain maximal amont prédéfini $G_{max}$. Par puissance inférieure à la puissance cible prédéfinie $P_c$, on entend par exemple une puissance de 2dB en-dessous de ladite puissance cible $P_c$.

La détermination de la puissance cible prédéfinie $P_c$ est connue en soi, et la puissance cible prédéfinie $P_c$ est par exemple déterminée en fonction de la forme d'onde à démoduler et également d'un PAPR (de l'anglais *Peak to Average Power Ratio*) de la forme d'onde pour avoir le maximum de dynamique au niveau du convertisseur analogique-numérique 24 sans provoquer de saturation.

En complément facultatif, notamment si le dispositif de réception comprend en outre l'amplificateur aval 22 connecté en sortie du mélangeur 18, le test de présence d'au moins un signal adjacent parasite dépend en outre d'un gain Γ de l'amplificateur aval 22.

Selon ce complément facultatif, le test de présence est par exemple positif si la puissance du signal en sortie du mélangeur 18 est inférieure à la puissance cible prédéfinie $P_c$ et si le gain G de l'amplificateur amont 14 est inférieur au gain maximal amont prédéfini $G_{max}$ et en outre si le gain $\Gamma$ de l'amplificateur aval 22 est sensiblement égal à un gain maximal aval prédéfini $\Gamma_{max}$.

Le choix du gain maximal amont prédéfini $G_{max}$, et le cas échéant du gain maximal aval prédéfini $\Gamma_{max}$, sont connus en soi. Chaque gain maximal prédéfini $G_{max}$, $\Gamma_{max}$ est dépendant de l'amplificateur concerné, et est qualifié sur le dispositif de réception 10 dans lequel est implémenté l'invention. Par exemple, pour un tuner silicium, le gain maximal amont prédéfini $G_{max}$ est sensiblement égal à 40dB, le gain maximal aval prédéfini $\Gamma_{max}$ est sensiblement égal à 25dB.

Le mélangeur 18 est connu en soi et est configuré pour mélanger le signal issu de l'amplificateur amont 14 - dit signal utile - avec le signal de référence, par exemple en multipliant ces deux signaux, la tension du signal en sortie du mélangeur étant alors le produit de la tension du signal utile et de la tension du signal de référence.

Le signal de référence est typiquement un signal non-modulé, par exemple un signal provenant de l'oscillateur local 20, et le mélangeur 18 est alors connecté à l'oscillateur local 20.

L'oscillateur local 20 est apte à fournir le signal de référence, tel que le signal non-modulé, ce signal non-modulé permettant, via le mélangeur 18, la transposition du signal utile vers une fréquence intermédiaire.

L'amplificateur aval 22 est connu en soi, et est adapté pour amplifier le signal issu du mélangeur 18.

Le convertisseur analogique-numérique 24 est connecté en sortie de l'amplificateur aval 22 lorsqu'il est présent, ou bien directement en sortie du mélangeur 18 en l'absence d'amplificateur aval, et est configuré pour convertir le signal analogique issu du mélangeur 18, éventuellement amplifié par l'amplificateur aval 22, en un signal numérique.

En complément facultatif, le convertisseur analogique-numérique 24 est configuré en outre pour mesurer la puissance du signal issu du mélangeur 18, notamment la première puissance P1 en l'absence de majoration de gain, puis la deuxième puissance P2 en présence de la majoration de gain $\Delta G$.

Chaque détecteur à large bande 26, 28 est connu en soi, et est apte à réguler l'amplification effectuée par l'amplificateur amont 14 en mesurant la puissance du signal issu de l'amplificateur amont 14 pour le premier détecteur à large bande 26, voire en mesurant la puissance du signal issu de l'antenne radioélectrique 12 pour le deuxième détecteur à large bande 28 lorsqu'il est présent, et en générant une consigne de gain afin de réguler la puissance si la puissance mesurée est en dehors d'une plage de puissances prédéfinie. Autrement dit, chaque détecteur à large bande 26, 28 vise à empêcher une amplification trop importante du signal radioélectrique par l'amplificateur amont 14, et plus généralement à limiter l'introduction par l'amplificateur amont 14 d'une non-linéarité sur le signal reçu.

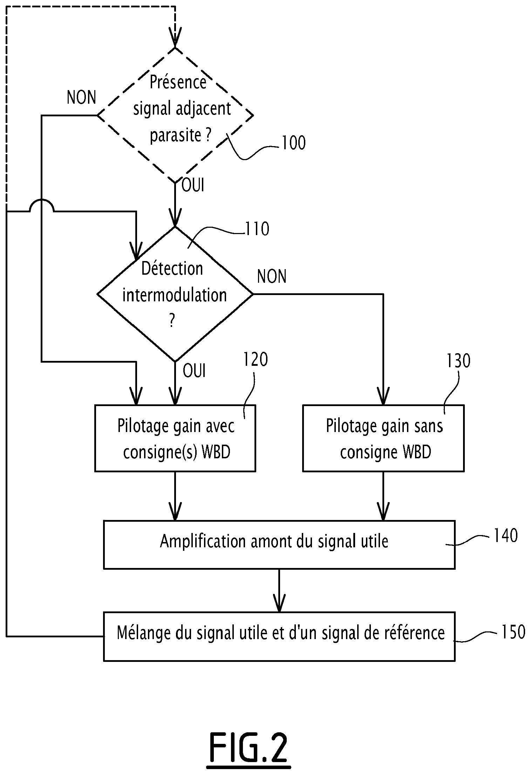

Le fonctionnement du dispositif électronique de réception 10 va désormais être expliqué à l'aide de la figure 2 représentant un organigramme du procédé, selon l'invention, de réception d'un signal radioélectrique.

Lors d'une étape initiale 100 facultative, le dispositif de réception 10 effectue, via son module de pilotage 16, un test de présence d'au moins un signal adjacent parasite à partir de la puissance du signal en sortie du mélangeur 18 et du gain G de l'amplificateur amont 14, voire à partir en outre du gain $\Gamma$ de l'amplificateur aval 22.

Le test de présence est par exemple positif si le gain G de l'amplificateur amont 14 est très inférieur au gain maximal amont prédéfini $G_{max}$ et si la puissance du signal en sortie du mélangeur 18 est strictement inférieure à la puissance cible prédéfinie $P_c$, le test de présence étant négatif autrement.

En variante, le test de présence est positif si le gain G de l'amplificateur amont 14 est inférieur au gain maximal amont prédéfini $G_{max}$, et si le gain $\Gamma$ de l'amplificateur aval 22 est sensiblement égal au gain maximal aval prédéfini $\Gamma_{max}$, et en outre si la puissance P du signal en sortie du mélangeur 18 est inférieure à la puissance cible prédéfinie $P_c$, le test de présence étant négatif autrement.

Si le test de présence effectué à l'étape initiale 100 est positif, alors le dispositif de réception 10 passe à l'étape suivante 110 au cours de laquelle il effectue, via son module de pilotage 16, une détection d'une éventuelle intermodulation. Cette détection d'intermodulation comporte la génération par l'amplificateur amont 14 de la majoration de gain $\Delta G$, puis la comparaison des première et deuxième puissances P1, P2 du signal issu du mélangeur 18, la première puissance P1 étant mesurée en l'absence de majoration de gain et la deuxième puissance P2 étant mesurée en présence de la majoration de gain $\Delta G$.

Lors de cette étape 110, le module de pilotage 16 considère alors qu'une intermodulation est présente lorsque la variation de la puissance P du signal en sortie du mélangeur 18, correspondant à la différence entre la deuxième puissance P2 et la première puissance P1, est non-linéaire par rapport à la majoration de gain $\Delta G$, typiquement si la différence entre la deuxième puissance P2 et la première puissance P1 est supérieure à sensiblement 1,5 fois la majoration de gain $\Delta G$. A titre d'exemple, si la variation de puissance P2-P1 vérifie l'inéquation (1) ou (2), alors le module de pilotage 16 considère qu'une intermodulation 16 est présente. Sinon, c'est-à-dire si la variation de puissance P2-P1 est sensiblement linéaire par rapport à la majoration de gain $\Delta G$, par exemple si les inéquations (1) ou (2) ne sont pas vérifiées, alors le module de pilotage 16 considère qu'aucune intermodulation n'est détectée.

Si la détection d'intermodulation effectuée lors de l'étape 110 est positive, c'est-à-dire si le module de pilotage 16 considère qu'une intermodulation est présente, alors le dispositif de réception 10 passe à l'étape 120 au cours de laquelle le module de pilotage 16 pilote le gain G de l'amplificateur amont 14 en tenant compte d'éventuelles consignes de modification du gain G issues du ou des détecteurs à large bande 26, 28.

Sinon, si la détection d'intermodulation est négative, c'est-à-dire si le module de pilotage 16 considère lors de l'étape 110 qu'aucune intermodulation n'est présente, alors le dispositif de réception 10 passe à l'étape 130 au cours de laquelle le module de pilotage 16 pilote le gain G de l'amplificateur amont 14 en ignorant d'éventuelles consignes issues du ou des détecteurs à large bande 26, 28.

Si à l'issue de l'étape initiale et facultative 100 de test de la présence d'au moins un signal adjacent parasite, le test est négatif, c'est-à-dire si aucun signal adjacent parasite n'est détecté, alors le dispositif de réception 10 passe directement de l'étape 100 à l'étape 120 de pilotage du gain pour tenir compte d'éventuelles consignes de modification du gain G issues du ou des détecteurs à large bande 26, 28.

L'homme du métier comprendra bien entendu que lorsque le dispositif de réception 10 n'effectue pas l'étape initiale 100 facultative, alors il débute le procédé de réception directement à l'étape 110.

A l'issue de l'étape 120 de pilotage du gain avec prise en compte de consigne(s) WBD ou bien à l'issue de l'étape 130 de pilotage du gain sans prise en compte de consigne(s) WBD, le dispositif de réception 10 amplifie ensuite, lors de l'étape 140, le signal radioélectrique reçu via son amplificateur amont 14.

Le dispositif de réception 10 mélange ensuite, lors de l'étape 150, le signal issu de l'amplificateur amont 14, dit signal utile, avec le signal de référence, de préférence non-modulé, via son mélangeur 18, et le signal analogique issu du mélangeur 18 est ensuite converti en le signal numérique par le convertisseur analogique-numérique 24.

Ce signal numérique converti par le convertisseur analogique-numérique 24 correspond au signal fourni en sortie du dispositif de réception 10. Le signal ainsi converti par le convertisseur analogique-numérique 24 est ensuite typiquement filtré numériquement, au besoin rééchantillonné (adaptation de la fréquence d'échantillonnage dans le cas de signaux numériques), et démodulé par un récepteur placé en sortie du dispositif de réception. Le signal démodulé devient alors un signal audio et/ou vidéo destiné à être reproduit par un dispositif tiers (autoradio, TV, etc.).

Le procédé de réception retourne ensuite à l'étape 100 ou à l'étape 110 selon que l'étape initiale 100 optionnelle est effectuée ou non, afin d'effectuer la réception d'un nouveau signal radioélectrique.

Ainsi, le dispositif électronique de réception 10 selon l'invention permet d'effectuer, plus simplement et via le module de pilotage 16, une détection d'une éventuelle intermodulation, en commandant la génération par l'amplificateur amont 14 de la majoration de gain $\Delta G$, puis en observant si la variation de puissance du signal issu du mélangeur 18, résultant de cette majoration de gain $\Delta G$, est une variation sensiblement linéaire, ou au contraire une variation non-linéaire, par rapport à la majoration de gain $\Delta G$ générée. Une intermodulation est alors considérée comme présente, si la variation de puissance P2-P1 du signal en sortie du mélangeur 18 est non-linéaire par rapport à la majoration de gain $\Delta G$. Corolairement, aucune intermodulation n'est considérée comme présente, si la variation de puissance P2-P1 est sensiblement linéaire par rapport à la majoration de gain $\Delta G$ générée.

La génération par l'amplificateur amont 14 de la majoration de gain $\Delta G$ est de préférence commandée de manière répétitive par le module de pilotage 16 afin d'effectuer cette détection d'intermodulation à intervalles temporels successifs.

L'écart temporel entre deux instants successifs $t_n$, $t_{n+1}$ de génération de deux majorations successives de gain $\Delta G_n$, $\Delta G_{n+1}$ dépend en outre de préférence de la détection ou non d'une intermodulation suite à la dernière majoration de gain $\Delta G_n$ et de la valeur du gain G de l'amplificateur amont 14 par rapport au gain maximal amont prédéfini $G_{max}$, ce qui permet de limiter le risque d'introduction d'éventuelles oscillations dues à cette détection d'intermodulation, et qui seraient alors potentiellement perturbatrices du signal délivré en sortie du dispositif de réception 10.

La génération de la majoration de gain $\Delta G$ est alors par exemple commandée de manière périodique avec une périodicité temporelle relativement faible, typiquement avec une période temporelle sensiblement égale à 1 ms, seulement si aucune intermodulation n'a été détectée suite à la dernière majoration de gain $\Delta G_n$ et si le gain G de l'amplificateur amont 14 est inférieur au gain maximal amont prédéfini $G_{max}$. Autrement, si le gain G de l'amplificateur amont 14 est sensiblement égal au gain maximal amont prédéfini $G_{max}$, alors l'écart temporel entre une prochaine majoration de gain $\Delta G_{n+1}$ et la majoration de gain précédente $\Delta G_n$ est nettement augmenté, typiquement sensiblement égal à 50 ms. De manière analogue, si une intermodulation a été détectée suite à la dernière majoration de gain $\Delta G_n$, alors l'écart temporel entre la prochaine majoration de gain $\Delta G_{n+1}$ et la dernière majoration de gain $\Delta G_n$ est également augmenté, cette augmentation étant toutefois moindre, l'écart temporel étant alors typiquement sensiblement égal à 20 ms, que dans le cas où le gain G de l'amplificateur amont 14 est sensiblement égal au gain maximal amont prédéfini $G_{max}$.

Le fait d'effectuer en complément facultatif un test de présence d'au moins un signal adjacent parasite, tel qu'au moins un signal adjacent fort, permet en outre d'effectuer la détection d'intermodulation seulement si celle-ci est nécessaire. En effet, si aucun signal adjacent parasite n'est détecté, il n'est alors pas nécessaire d'effectuer ensuite une détection d'intermodulation, et le procédé de réception passe alors directement dans ce cas de l'étape 100 à l'étape 120.

On conçoit ainsi que le dispositif électronique de réception 10 selon l'invention permet d'effectuer la détection d'une éventuelle intermodulation de manière plus simple qu'avec un dispositif électronique de réception de l'état de la technique.

**Revendications**

1. Dispositif électronique (10) de réception d'un signal radioélectrique, le dispositif (10) comprenant :

   - un amplificateur amont (14) configuré pour amplifier un signal radioélectrique reçu,
   - un module de pilotage (16) configuré pour piloter un gain (G) de l'amplificateur amont (14), et
   - un mélangeur (18) connecté en sortie de l'amplificateur amont (14), le mélangeur (18) étant configuré pour mélanger le signal issu de l'amplificateur amont (14) avec un signal de référence,

   **caractérisé en ce que** le module de pilotage (16) est configuré en outre pour effectuer une détection d'intermodulation, en commandant la génération par l'amplificateur amont (14) d'une majoration de gain ($\Delta G$) et en comparant une première puissance (P1) avec une deuxième puissance (P2), les première et deuxième puissances (P1, P2) étant des puissances respectives d'un signal en sortie du mélangeur (18), la première puissance (P1) étant mesurée en l'absence de majoration de gain et la deuxième puissance (P2) étant mesurée en présence de la majoration de gain ($\Delta G$),

   le module de pilotage (16) étant configuré pour commander répétitivement la génération de la majoration de gain ($\Delta G$),
   l'écart temporel entre une nouvelle majoration de gain et la dernière majoration de gain ($\Delta G_n$) étant augmenté en cas de détection d'une intermodulation suite à la dernière majoration de gain ($\Delta G_n$).

2. Dispositif (10) selon la revendication 1, dans lequel une intermodulation est détectée si une différence entre la deuxième puissance (P2) et la première puissance (P1) est supérieure à sensiblement 1,5 fois la majoration de gain ($\Delta G$).

3. Dispositif (10) selon la revendication 1 ou 2, dans lequel l'écart temporel entre deux majorations successives de gain est sensiblement égal à 1 ms si aucune intermodulation n'a été détectée suite à la dernière majoration de gain ($\Delta G_n$) et si le gain (G) de l'amplificateur amont (14) est inférieur à un gain maximal amont prédéfini ($G_{max}$).

4. Dispositif (10) selon l'une quelconque des revendications précédentes, dans lequel le dispositif (10) comprend en outre un amplificateur aval (22) connecté en sortie du mélangeur (18) et un convertisseur analogique-numérique (24) connecté en sortie de l'amplificateur aval (22),
   le convertisseur analogique-numérique (24) étant de préférence configuré pour mesurer les première et deuxième puissances (P1, P2).

5. Dispositif (10) selon l'une quelconque des revendications précédentes, dans lequel le module de pilotage (16) est en outre configuré pour, préalablement à une détection d'intermodulation, effectuer un test de présence d'au moins un signal adjacent parasite, et pour effectuer alors la détection d'intermodulation seulement si le test de présence est positif, ledit test de présence dépendant de la puissance du signal en sortie du mélangeur (18) et du gain (G) de l'amplificateur amont (14).

6. Dispositif (10) selon la revendication 5, dans lequel le test de présence est positif si le gain (G) de l'amplificateur amont (14) est inférieur à un gain maximal amont prédéfini ($G_{max}$) et si la puissance du signal en sortie du mélangeur (18) est strictement inférieure à une puissance cible prédéfinie ($P_c$).

7. Dispositif (10) selon les revendications 4 et 5, dans lequel le test de présence dépend en outre d'un gain ($\Gamma$) de l'amplificateur aval (22),
   le test de présence étant de préférence positif si le gain (G) de l'amplificateur amont (14) est inférieur à un gain maximal amont prédéfini ($G_{max}$), si le gain ($\Gamma$) de l'amplificateur aval (22) est sensiblement égal à un gain maximal aval prédéfini ($\Gamma_{max}$) et si la puissance du signal en sortie du mélangeur (18) est inférieure à une puissance cible prédéfinie ($P_c$).

8. Dispositif (10) selon l'une quelconque des revendications précédentes, dans lequel le dispositif (10) comprend en outre un premier détecteur à large bande (26) connecté entre la sortie de l'amplificateur amont (14) et le module de pilotage (16).

9. Dispositif (10) selon l'une quelconque des revendications précédentes, dans lequel le dispositif (10) comprend en outre une antenne radioélectrique (12) apte à recevoir un signal radioélectrique, et un deuxième détecteur à large bande (28) connecté entre l'antenne radioélectrique (12) et le module de pilotage (16).

10. Circuit intégré implémentant un dispositif électronique (10) de réception d'un signal radioélectrique, **caractérisé en ce que** le dispositif (10) est selon l'une quelconque des revendications précédentes.

11. Procédé de réception d'un signal radioélectrique, le procédé étant mis en oeuvre par un dispositif électronique de réception (10) et comprenant les étapes consistant à :

- piloter un gain d'un amplificateur amont (14), et
- amplifier, via l'amplificateur amont (14), un signal radioélectrique reçu,
- mélanger le signal issu de l'amplificateur amont (14) avec un signal de référence, **caractérisé en ce que** le procédé comprend en outre l'étape consistant à :
- effectuer une détection d'intermodulation, en commandant la génération par l'amplificateur amont (14) d'une majoration de gain ($\Delta G$) et en comparant une première puissance (P1) avec une deuxième puissance (P2), les première et deuxième puissances (P1, P2) étant des puissances respectives d'un signal en sortie du mélangeur (18), la première puissance (P1) étant mesurée en l'absence de majoration de gain et la deuxième puissance (P2) étant mesurée en présence de la majoration de gain ($\Delta G$),
la génération de la majoration de gain ($\Delta G$) étant commandée répétitivement,
si une intermodulation a été détectée suite à la dernière majoration de gain ($\Delta G_n$), alors l'écart temporel entre une nouvelle majoration de gain et la dernière majoration de gain ($\Delta G_n$) est augmenté.

**Patentansprüche**

1. Elektronische Vorrichtung (10) zum Empfangen eines Funksignals, wobei die Vorrichtung (10) Folgendes umfasst:

- einen vorgeschalteten Verstärker (14), der konfiguriert ist, um ein empfangenes Funksignal zu verstärken,
- ein Steuerungsmodul (16), das konfiguriert ist, um eine Verstärkung (G) des vorgeschalteten Verstärkers (14) zu steuern, und
- einen Mischer (18), der an dem Ausgang des vorgeschalteten Verstärkers (14) angeschlossen ist, wobei der Mischer (18) konfiguriert ist, um das Signal aus dem vorgeschalteten Verstärker (14) mit einem Referenzsignal zu mischen,
**dadurch gekennzeichnet, dass** das Steuerungsmodul (16) ferner konfiguriert ist, um eine Intermodulationsdetektion durchzuführen, indem es die Erzeugung einer Verstärkungserhöhung ($\Delta G$) durch den vorgeschalteten Verstärker (14) veranlasst und eine erste Leistung (P1) mit einer zweiten Leistung (P2) vergleicht, wobei die erste und die zweite Leistung (P1, P2) jeweilige Leistungen eines Signals am Ausgang des Mischers (18) sind, wobei die erste Leistung (P1) ohne Verstärkungserhöhung und die zweite Leistung (P2) bei Vorhandensein der Verstärkungserhöhung ($\Delta G$) gemessen wird,
wobei das Steuerungsmodul (16) konfiguriert ist, um die Erzeugung der Verstärkungserhöhung ($\Delta G$) wiederholt zu veranlassen,
wobei die Zeitdifferenz zwischen einer neuen Verstärkungserhöhung und der letzten Verstärkungserhöhung ($\Delta G_n$) vergrößert wird, wenn nach der letzten Verstärkungserhöhung ($\Delta G_n$) eine Intermodulation erkannt wird.

2. Vorrichtung (10) nach Anspruch 1, wobei eine Intermodulation erkannt wird, wenn eine Differenz zwischen der zweiten Leistung (P2) und der ersten Leistung (P1) größer als im Wesentlichen das 1,5-fache der Verstärkungserhöhung ($\Delta G$) ist.

3. Vorrichtung (10) nach Anspruch 1 oder 2, wobei die Zeitdifferenz zwischen zwei aufeinanderfolgenden Verstärkungserhöhungen im Wesentlichen gleich 1 ms ist, wenn nach der letzten Verstärkungserhöhung ($\Delta G_n$) keine Intermodulation erkannt wurde und wenn die Verstärkung (G) des vorgeschalteten Verstärkers (14) kleiner als eine vorgegebene maximale vorgeschaltete Verstärkung ($G_{max}$) ist.

4. Vorrichtung (10) nach einem der vorstehenden Ansprüche, wobei die Vorrichtung (10) ferner einen nachgeschalteten Verstärker (22), der an dem Ausgang des Mischers (18) angeschlossen ist, und einen Analog-Digital-Wandler (24) umfasst, der am Ausgang des nachgeschalteten Verstärkers (22) angeschlossen ist,
wobei der Analog-Digital-Wandler (24) vorzugsweise so konfiguriert ist, um die erste und die zweite Leistung (P1, P2) zu messen.

**5.** Vorrichtung (10) nach einem der vorstehenden Ansprüche, wobei das Steuerungsmodul (16) ferner konfiguriert ist, um, vor einer Intermodulationsdetektion, einen Test auf das Vorhandensein mindestens eines parasitären Nachbarsignals durchzuführen und die Intermodulationsdetektion nur dann durchzuführen, wenn der Präsenztest positiv ist, wobei der Präsenztest von der Leistung des Signals am Ausgang des Mischers (18) und von der Verstärkung (G) des vorgeschalteten Verstärkers (14) abhängt.

**6.** Vorrichtung (10) nach Anspruch 5, wobei der Präsenztest positiv ist, wenn die Verstärkung (G) des vorgeschalteten Verstärkers (14) kleiner als eine vorgegebene maximale vorgeschaltete Verstärkung ($G_{max}$) ist und wenn die Leistung des Signals am Ausgang des Mischers (18) streng kleiner als eine vorgegebene Zielleistung ($P_c$) ist.

**7.** Vorrichtung (10) nach den Ansprüchen 4 und 5, wobei der Präsenztest auch von einer Verstärkung ($\Gamma$) des nachgeschalteten Verstärkers (22) abhängt,
wobei der Präsenztest vorzugsweise positiv ist, wenn die Verstärkung (G) des vorgeschalteten Verstärkers (14) kleiner als eine vorgegebene maximale vorgeschaltete Verstärkung ($G_{max}$) ist, wenn die Verstärkung ($\Gamma$) des nachgeschalteten Verstärkers (22) im Wesentlichen gleich einer vorgegebenen maximalen nachgeschalteten Verstärkung ($\Gamma_{max}$) ist und wenn die Leistung des Signals am Ausgang des Mischers (18) kleiner als eine vorgegebene Zielleistung ($P_c$) ist.

**8.** Vorrichtung (10) nach einem der vorstehenden Ansprüche, wobei die Vorrichtung (10) ferner einen ersten Breitbanddetektor (26) umfasst, der zwischen dem Ausgang des vorgeschalteten Verstärkers (14) und dem Steuerungsmodul (16) angeschlossen ist.

**9.** Vorrichtung (10) nach einem der vorstehenden Ansprüche, wobei die Vorrichtung (10) ferner eine Funkantenne (12), die geeignet ist, ein Funksignal zu empfangen, und einen zweiten Breitbanddetektor (28) umfasst, der zwischen der Funkantenne (12) und dem Steuerungsmodul (16) angeschlossen ist.

**10.** Integrierte Schaltung, die eine elektronische Vorrichtung (10) zum Empfang eines Funksignals implementiert, **dadurch gekennzeichnet, dass** die Vorrichtung (10) einem der vorstehenden Ansprüche entspricht.

**11.** Verfahren zum Empfangen eines Funksignals, wobei das Verfahren durch eine elektronische Empfangsvorrichtung (10) implementiert wird und die folgenden Schritte umfasst:

- Steuern einer Verstärkung eines vorgeschalteten Verstärkers (14), und
- Verstärken, über den vorgeschalteten Verstärker (14), eines empfangenen Funksignals,
- Mischen des Signals von dem vorgeschalteten Verstärker (14) mit einem Referenzsignal, **dadurch gekennzeichnet, dass** das Verfahren ferner den folgenden Schritt umfasst:
- Durchführen einer Intermodulationsdetektion, indem die Erzeugung einer Verstärkungserhöhung ($\Delta G$) durch den vorgeschalteten Verstärker (14) veranlasst und eine erste Leistung (P1) mit einer zweiten Leistung (P2) verglichen wird, wobei die erste und die zweite Leistung (P1, P2) jeweilige Leistungen eines Signals am Ausgang des Mischers (18) sind, wobei die erste Leistung (P1) ohne Verstärkungserhöhung und die zweite Leistung (P2) bei Vorhandensein der Verstärkungserhöhung ($\Delta G$) gemessen wird,
wobei die Erzeugung der Verstärkungserhöhung ($\Delta G$) wiederholt veranlasst wird,
wenn nach der letzten Verstärkungserhöhung ($\Delta G_n$) eine Intermodulation erkannt wurde, wird die Zeitdifferenz zwischen einer neuen Verstärkungserhöhung und der letzten Verstärkungserhöhung ($\Delta G_n$) dann erhöht.

**Claims**

**1.** An electronic device (10) for receiving a radio frequency signal, the device (10) comprising:

- an upstream amplifier (14) configured to amplify a received radio frequency signal,
- a driving module (16) configured to drive a gain (G) of the upstream amplifier (14), and
- a mixer (18) connected at the output of the upstream amplifier (14), the mixer (18) being configured to mix the signal from the upstream amplifier (14) with a reference signal,
**characterized in that** the driving module (16) is further configured to perform an intermodulation detection, by controlling the generating by the upstream amplifier (14) of an increase in gain ($\Delta G$) and by comparing a first power (P1) with a second power (P2), the first and second powers (P1, P2) being respective powers of a signal at the output of the mixer (18), the first power (P1) being measured in the absence of an increase in gain and the second power (P2) being measured in the presence of an increase in gain ($\Delta G$),
the driving module (16) being configured to repeatedly control the generating of the increase in gain ($\Delta G$),
the time difference between a new increase in gain and the last increase in gain ($\Delta G_n$) being raised in the event of detection of an intermodulation following the last increase in gain ($\Delta G_n$).

2. The device (10) according to claim 1, wherein an intermodulation is detected if a difference between the second power (P2) and the first power (P1) is greater than substantially 1.5 times the increase in gain ($\Delta G$).

3. The device (10) according to claim 1 or 2, wherein the time difference between two successive increases in gain is substantially equal to 1 ms if no intermodulation has been detected following the last increase in gain ($\Delta G_n$) and if the gain (g) of the upstream amplifier (14) is less than a predefined upstream maximum gain ($G_{max}$).

4. The device (10) according to any one of the preceding claims, wherein the device (10) further comprises a downstream amplifier (22) connected at the output of the mixer (18) and an analog-to-digital converter (24) connected at the output of the downstream amplifier (22),
wherein the analog-to-digital converter (24) is preferably configured to measure the first and second powers (P1, P2).

5. The device (10) according to any one of the preceding claims, wherein the driving module (16) is further configured to, prior to an intermodulation detection, perform a test of presence of at least one adjacent interfering signal, and to then perform the intermodulation detection only if the presence test is positive, said presence test depending on the power of the signal at the output of the mixer (18) and the gain (G) of the upstream amplifier (14).

6. The device (10) according to claim 5, wherein the presence test is positive if the gain (G) of the upstream amplifier (14) is less than a predefined upstream maximum gain ($G_{max}$) and if the power of the signal at the output of the mixer (18) is strictly less than a predefined target power ($P_c$).

7. The device (10) according to claims 4 and 5, wherein the presence test further depends on a gain ($\Gamma$) of the downstream amplifier (22),
the presence test being preferably positive if the gain (G) of the upstream amplifier (14) is less than a predefined upstream maximum gain ($G_{max}$), if the gain ($\Gamma$) of the downstream amplifier (22) is substantially equal to a predefined downstream maximum gain ($\Gamma_{max}$) and if the power of the signal at the output of the mixer (18) is less than a predefined target power ($P_c$).

8. The device (10) according to any one of the preceding claims, wherein the device (10) further comprises a first broadband detector (26) connected between the output of the upstream amplifier (14) and the driving module (16).

9. The device (10) according to any one of the preceding claims, wherein the device (10) further comprises a radio-frequency antenna (12) capable of receiving a radio frequency signal, and a second broadband detector (28) connected between the radio-frequency antenna (12) and the driving module (16).

10. An integrated circuit implementing an electronic device (10) for receiving a radio frequency signal, **characterized in that** the device (10) is according to any one of the preceding claims.

11. A method for receiving a radio frequency signal, the method being performed by a receiving electronic device (10) and comprising the steps of:

    - driving a gain of an upstream amplifier (14), and
    - amplifying, via the upstream amplifier (14), a received radio frequency signal,
    - mixing the signal from the upstream amplifier (14) with a reference signal, **characterized in that** the method further comprises the step of:
    - performing an intermodulation detection, by controlling the generating by the upstream amplifier (14) of an increase in gain ($\Delta G$) and by comparing a first power (P1) with a second power (P2), the first and second powers (P1, P2) being respective powers of a signal at the output of the mixer (18), the first power (P1) being measured in the absence of an increase in gain and the second power (P2) being measured in the presence of an increase in gain ($\Delta G$),
    the generating of the increase in gain ($\Delta G$) being repeatedly controlled,
    if an intermodulation has been detected following the last increase in gain ($\Delta G_n$), then the time difference between a new increase in gain and the last increase in gain ($\Delta G_n$), is increased.

FIG.1

NON

Présence
signal adjacent
parasite ? —100

OUI

—110

Détection
intermodulation
?

NON

120                    130

OUI

Pilotage gain avec
consigne(s) WBD

Pilotage gain sans
consigne WBD

Amplification amont du signal utile —140

Mélange du signal utile et d'un signal de référence —150

FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20040043733 A1
- US 20080102773 A1
- US 20080153447 A1
- US 6134430 A
- US 2003181180 A1
- US 7379725 B